# EUROPEAN PATENT APPLICATION

(11) **EP 2 562 000 A1**
(43) Date of publication of application: **27.02.2013**
(21) Application number: 12181727.4
(22) Date of filing: 24.08.2012
(51) Int. Cl.: B41M 3/00, H01L 31/0224, H01L 31/18, H05K 3/12

(54) **Method and apparatus for printing a multilayer pattern**

(30) Priority: 25.08.2011 IT UD20110135; 06.06.2012 US 201261656255 P
(71) Applicant: Applied Materials Italia Srl, 31048 San Biagio di Callalta (IT)
(72) Inventor: Vercesi, Tommaso, 31057 Silea (TV) (IT); Boscolo Marchi, Enrico, 30015 Chioggia (VE) (IT)
(74) Representative: Petraz, Gilberto Luigi

(57) **Abstract**

The present invention provides a control method and apparatus for printing a multilayer pattern on a substrate. In one embodiment, a method for printing a multilayer pattern includes a first printing operation comprising depositing a first patterned layer on a region of a surface of the substrate, a second printing operation comprising depositing a second patterned layer over the region of the surface or first patterned layer, and verifying the precision of the alignment of the second patterned layer relative to the first patterned layer. Verifying comprises acquiring a first optical image of the first patterned layer after the first printing operation, acquiring a second optical image of the second patterned layer after the second printing operation, and determining the position of the second patterned layer by performing an image subtraction process to form a first subtracted optical image and comparing the subtracted optical image with the first image.

## Description

### BACKGROUND OF THE INVENTION

### Field of the Invention

Embodiments of the invention generally relate to a method and apparatus for printing a multilayer pattern on a substrate, which can be used to form a photovoltaic cell or a green-tape type circuit device. In particular, the method according to the present invention can be used in a system for producing multilayer patterns by means of multilayer printing on a substrate, whether by silk-screen printing, ink-jet printing, laser printing or other type of printing.

### Description of the Related Art

Solar cells are photovoltaic (PV) devices that convert sunlight directly into electrical power. The PV market has experienced growth at annual rates exceeding 30% for the last ten years. Some articles suggest that solar cell power production world-wide may exceed 10 GWp in the near future. It is estimated that more than 95% of all solar modules are silicon wafer based. The high market growth rate in combination with the need to substantially reduce solar electricity costs has resulted in a number of serious challenges for inexpensively forming high quality solar cells. Therefore, one major component in making commercially viable solar cells lies in reducing the manufacturing costs required to form the solar cells by improving the device yield and increasing the substrate throughput.

Solar cells typically have one or more p-n junctions. Each p-n junction comprises two different regions within a semiconductor material where one side is denoted as the p-type region and the other as the n-type region. When the p-n junction of a solar cell is exposed to sunlight (consisting of energy from photons), the sunlight is directly converted to electricity through the PV effect.

Solar cells generate a specific amount of electric power and are tiled into modules sized to deliver the desired amount of system power. Solar modules are joined into panels with specific frames and connectors. Solar cells are commonly formed on silicon substrates, which may be single or multicrystalline silicon substrates. A typical solar cell includes a silicon wafer, substrate, or sheet typically less than about 0.3 mm thick with a thin layer of n-type silicon on top of a p-type region formed on the substrate.

Generally, a standard silicon solar cell is fabricated on a wafer which includes a p-type base region, an n-type emitter region, and a p-n junction region disposed therebetween. An n-type region, or n-type semiconductor, is formed by doping the semiconductor with certain types of elements (e.g. phosphorous (P), arsenic (As) or antimony (Sb)), in order to increase the number of negative charge carriers, i.e. electrons. Similarly, a p-type region, or p-type semiconductor, is formed by the addition of trivalent atoms to the crystal lattice, resulting in a missing electron from one of the four covalent bonds normal for the silicon lattice. Thus, the dopant atom can accept an electron from a neighboring atom's covalent bond to complete the fourth bond. The dopant atom accepts an electron, causing the loss of half of one bond from the neighboring atom and resulting in the formation of a "hole."

When light falls on the solar cell, energy from the incident photons generates electron-hole pairs on both sides of the p-n junction region. Electrons diffuse across the p-n junction to a lower energy level, and holes diffuse in the opposite direction, creating a negative charge on the emitter and a corresponding positive charge builds up in the base. When an electrical circuit is made between the emitter and the base, and the p-n junction is exposed to certain wavelengths of light, a current will flow. The electrical current generated by the semiconductor, when illuminated, flows through contacts disposed on the frontside, i.e. the light-receiving side, and the backside of the solar cell. The top contact structure is generally configured as widely-spaced thin metal lines, or fingers, that supply current to larger bus bars. The back contact is generally not constrained to be formed in multiple thin metal lines, since it does not prevent incident light from striking solar cell. Solar cells are generally covered with a thin layer of dielectric material, such as Si₃N₄, to act as an antireflection coating 16, or ARC, to minimize light reflection from the top surface of solar cell.

Screen printing has long been used in printing designs on objects, such as cloth or ceramics, and is used in the electronics industry for printing electrical component designs, such as electrical contacts or interconnects on the surface of a substrate. State of the art solar cell fabrication processes also use screen printing processes. In some applications, it is desirable to screen print contact lines, such as fingers, on the solar cell substrate. The fingers are in contact with the substrate and are able to form an Ohmic connection with one or more doped regions (e.g. n-type emitter region). An Ohmic contact is a region on a semiconductor device that has been prepared so that the current-voltage (I-V) curve of the device is linear and symmetric, i.e., there is no high-resistance interface between the doped silicon region of the semiconductor device and the metal contact. Low resistance, stable contacts are critical for the performance of the solar cell and reliability of the circuits formed in the solar cell fabrication process. To enhance the contact with the solar cell device it is typical to position a finger on a heavily doped region formed within the substrate surface to enable the formation of an Ohmic contact. Since the formed heavily doped regions, due to their electrical properties, tend to block or minimize the amount of light that can pass there through, it is desirable to minimize their size, while also making these regions large enough to assure that the fingers can be reliably aligned and formed thereon. The misalignment of the deposited fingers to the underlying heavily doped regions due to errors in the positioning of the substrate on an automated transferring device causes defects in the edge of the substrate. Unknown registration and misalignment of the heavily doped region on the substrate surface and/or shifting of the substrate on the automated transferring device, can lead to a poor device performance and low device efficiency.

Heavily doped regions may be formed on the substrate surface using a variety of patterning techniques to create areas of heavier and lighter doping, for example by performing phosphorous diffusion operations using a patterned diffusion barrier. A backside contact completes the electrical circuit required for solar cell to produce a current by forming an Ohmic contact with p-type base region of the substrate.

Methods are also known for the production of multilayer patterns, e.g. for so-called double printing, by means of several successive printing operations, for example silk-screen printing, laser, ink jet or other similar processes, on a suitable support or substrate, for example a wafer with a silicon or alumina base.

The multilayer structures, for example formed by a first printed layer and a second printed layer superimposed upon the first, allow to increase the current delivered from the contacts, but make the printing process more complex since one needs to assure that the various layers are correctly aligned with each other, with a precision generally in the range of 10 microns (mm). Typically, if the movement of the substrate on an automated transfer device and the movement of a printing head are not well controlled, the deposited pattern will be improperly formed. Consequently, in the event of an error during a printing process operation, the misalignments of the printed multiple layers will cause the substrate to be discarded. Therefore, there is a need for one or more control operations after each printing operation, to verify the alignment of the layers printed on each occasion with respect to the layers below.

Some known control techniques need to know the position of the printed layers in order to use this information for a closed-ring retroaction control. However, once a given layer has been printed on the lower layer, it is particularly difficult to know the exact position of the successive layers because, all in all, they are superimposed. Therefore, there is a need for a method and apparatus for the manufacturing of solar cells, electronic circuits, or other useful devices that has an improved method of controlling the alignment of double layered screen printing patterns on a substrate within the system.

### SUMMARY OF THE INVENTION

The present invention provides a control method and apparatus for printing a multilayer pattern on a substrate. In one embodiment, a method for printing a multilayer pattern on a substrate includes at least one first printing operation comprising depositing a first patterned layer on a region of a surface of the substrate, at least one subsequent operation of aligning the substrate, propaedeutic for a second or subsequent printing operation, at least one second printing operation comprising depositing a second patterned layer over the region of the surface or first patterned layer, and at least one operation of verifying the precision of the alignment of the second patterned layer relative to the first patterned layer. Verifying comprises acquiring a first optical image of the first patterned layer after the first printing operation and before the second printing operation, acquiring at least one second optical image of the second patterned layer after the second printing operation, and at least one operation of determining the position of the second patterned layer on the substrate by performing a first image subtraction process, wherein the first image subtraction process comprises subtracting the first optical image from the second optical image to form a first subtracted optical image, and comparing the first subtracted optical image with the first optical image, wherein data created from the comparison is used to adjust a property of a subsequent printing operation. According to the invention, the outcome of the determining operation is used both in feedback for a closed-ring retroaction control of the second or subsequent printing operation and also used in an operation of controlling the quality of printing of the second subsequent patterned layer

In one embodiment, an apparatus for printing a multilayer pattern on a substrate includes a first printing station configured to print a first patterned layer on the substrate, a first device operable to align the substrate, at least one second printing station, operable to print a second patterned layer on the substrate over the first patterned layer; and at least a control means, operable to verify the precision of the alignment after the printing of the second patterned layer and operable to feed back data from the verification of the precision to the at least one means for alignment. The control means further comprises a detection device operable to acquire a first optical image of the first patterned layer before the second layer is printed, and acquire at least a second optical image of the second patterned layer printed on the first patterned layer and a control and command unit operable to carry out image calculation by mage subtraction between the second optical image and the first optical image in order to determine an actual position on the substrate of the second patterned printed layer, wherein the control and command unit is further operable to feed back an outcome of the image calculation to a quality control station.

### BRIEF DESCRIPTION OF THE DRAWINGS

So that the manner in which the above-recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is one embodiment of a method for screen printing;

Figure 2 is one embodiment of a method for screen printing;

Figure 3 is a schematic view of a system that is able to carry out the methods in Figures 1 and 2;

Figure 4 is a schematic view of a system that is able to carry out the methods in Figures 1 and 2;

Figure 5 is one embodiment of a method for image subtraction;

Figure 6 is a plan view of a substrate;

Figure 7 is a side cross-sectional view of a portion of the substrate illustrated in Figure 6;

Figure 8 is a side cross-sectional view of a portion of the substrate illustrated in Figure 6;

Figure 9 is schematic isometric view of one embodiment of a screen printing system;

Figure 10 is a schematic top plan view of the screen printing system of Figure 9;

Figure 11 is a schematic top plan view illustrating one embodiment of a screen printing system;

Figure 12 is a schematic isometric view of one embodiment of an optical inspection system;

Figure 13 is a schematic isometric view of one embodiment of an optical inspection system; and

Figure 14 is a schematic isometric view of one embodiment of an optical inspection system.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

Embodiments of the invention generally provide a method for printing a multilayer pattern on a substrate, which is based on a closed-loop or closed-ring retro-action control that uses the results of an image subtraction calculation performed by a control unit to provide the precise alignment of a series of printed layers. This improves the device yield performance and the cost of ownership (CoO) of a substrate processing line.

With the embodiments of the invention, thanks to the processing by image subtraction, it is possible to isolate optically the last printed layer from the previous ones, eliminating the disturbances connected thereto, and it is easier to know exactly the actual position of the successive printed layers, even though, overall, they are superimposed on top of each other. Moreover, the invention offers the advantage that it uses the same acquisition operation and the same detection or vision system both to control the alignment of the layers of the multilayer pattern in closed-ring retro-action, and also for the quality control.

One advantage of the invention is that the control based on image subtraction adapts well to the double screen-printing process where it is necessary to use the same screen-printing net, and it is not possible to use different nets.

This increases the process speed in that, with a single acquisition, it is possible to effect both the retro-action control and also the quality control.

Furthermore, the method and apparatus according to the invention are more economical and compact, and do not need a dedicated vision system for the quality control.

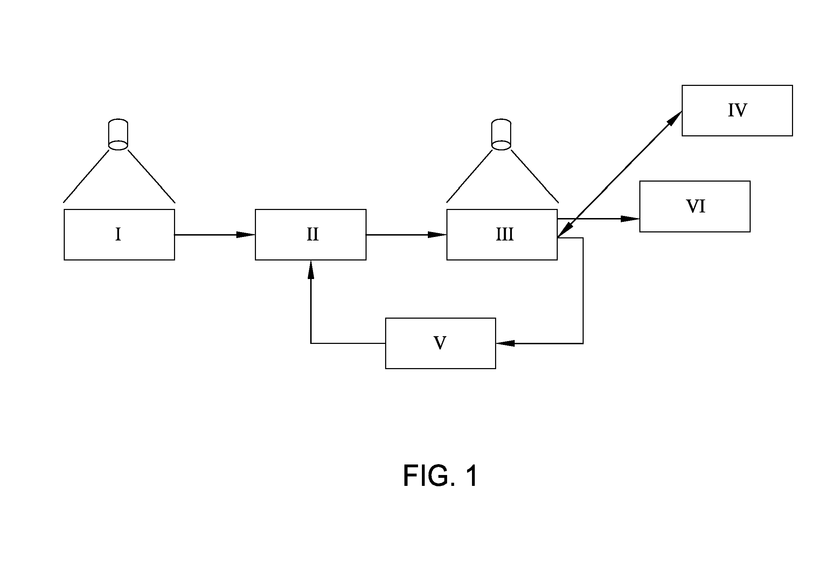

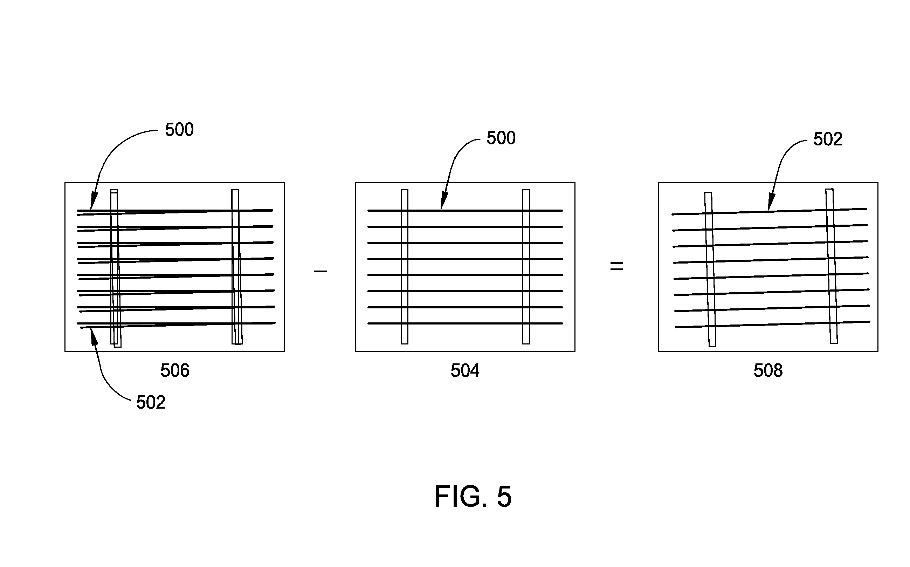

Figure 1 provides a method for screen printing. In Figure 1, block I indicates the operation of acquiring a first image 504 of a first printed layer 500 disposed on a substrate 501, as illustrated in Figure 5. Block II indicates a first printing operation used to dispose a second layer 502 over the first printed layer 500, as shown in Figure 5. Block III indicates the operation of acquiring a second image 506 of the second layer 502 printed over the first layer 500. Block IV indicates a operation of analyzing the acquired images, which includes performing an image subtraction process. Block V indicates the closed-loop, or closed-ring retro-action, used to provide data back to the control elements used in block II, based on the outcome of the analyses performed in block IV, to improve the performance of the processes performed therein. Block VI indicates a quality control processing technique, which is based on the outcome of the calculation performed in block IV, which is used to improve the method described in Figure 1.

Figure 5 graphically illustrates acquired images and outcome of the image subtraction operation discussed above in conjunction with Figure 1. As illustrated in Figure 5, an acquired second image 506 may typically include a second layer 502 being misaligned with respect to the prior deposited first layer 500. Therefore, if the first image 504 of the first layer 500 disposed on the substrate 501, is subtracted from the second image 506, a subtracted image or a third image 508 of the individual second layer 502 can be formed, analyzed and/or used by a control system to better control the multilayer deposition and processing sequence. The subtracted image 508 may be an individual optical image of the second image 506 of the second layer 502.

In one embodiment, a system is adapted to perform a screen printing process according to the present invention within a portion of a crystalline silicon solar cell production line. The processes performed in the portion of the solar cell production line may include patterning a substrate with a desired material and then processing it in one or more subsequent processing chambers. The subsequent processing chambers may be adapted to perform one or more bake operations and one or more cleaning operations.

While the discussion herein primarily discusses the process of screen printing a pattern, such as a contact or interconnect structure, on a surface of a solar cell device, this configuration is not intended to be limiting as to the scope of the invention described herein. Other substrate materials that may benefit from the invention include substrates that may have an active region that are formed on or within a single crystal silicon, a multi-crystalline silicon, a polycrystalline silicon or other desirable substrate materials.

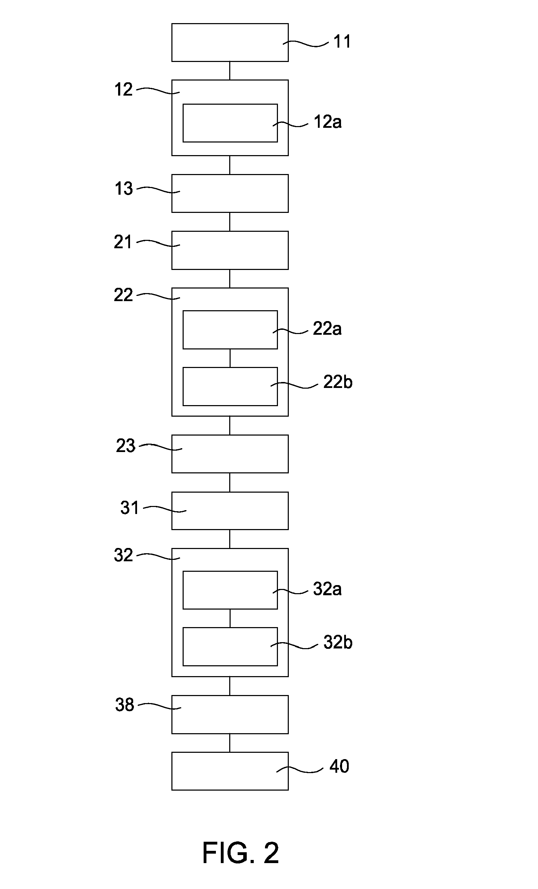

Figure 2 provides a method for screen printing. In one embodiment, the method comprises at least one first printing operation 11 on a substrate, and one or more additional printing operations, such as the second and the third printing operations 21, 31. A first and second alignment operation 13, 23 are also provided. The first alignment operation 13 is performed between the first printing operation 11 and the second printing operation 21. The second alignment operation 23 is performed between the second printing operation 21 and the third printing operation 31. A first, second, and third verification operation 12, 22, 32 verify the precision of the alignment after printing operations 11, 21 and 31, respectively. A quality control operation 38 and a discharge operation 40 are performed after the third verification operation 32. It is contemplated that embodiments of the invention may further provide, or be adapted to provide, for methods which have more than three printing operations, and also to more simple cases with two or less printing operations.

In one embodiment of the present invention, each verification operation 12, 22, 32 comprises acquiring optical image operations that are performed both upstream and downstream of corresponding printing operations. An optical image is defined by an image detected with light in the visible range, in the infrared range or other suitable wavelength(s) of light by use of a detector. In one embodiment, each optical image is formed by use of a detector assembly that includes a camera that is configured to detect and resolve features on a surface of a substrate within a desired wavelength range emitted by one or more of the radiation sources disposed within the system. In one embodiment, the camera comprises a CCD camera that is adapted to form a digital image of the surface of the substrate.

After printing operation 11 and before printing operation 21, a first optical image of a first patterned layer printed on the substrate is acquired at operation 12a. After printing operation 21 and before printing operation 31, a second and third optical image are acquired at operation 22a of the further patterned layer printed on the substrate. After printing operation 31 a fourth optical image is acquired at operation 32a of the further patterned layer printed on the substrate. Calculation operations 22b, 32b determine the actual position of the further patterned layer by image subtraction between the optical image of the further patterned layer and a prior acquired optical image, such as the first optical image. This information is used both in closed-loop processes to control the alignment of the printing of the further patterned layer on said patterned layer, and also in the quality control downstream of the further printing operations 21, 31.

In some embodiments, the image subtraction operation is associated with a superimposition of the second image on top of the first image, obtaining an overall image that reproduces the two print patterns printed one on top of the other. The image subtraction operation is carried out by subtracting pixel from pixel between the two images acquired in the overall image obtained by the superimposition.

In some embodiments, in the overall image obtained by the superimposition, pixels of the first image of the first printed pattern are subtracted from mating pixels of the second image of the second printed pattern.

If the second pattern has been printed correctly aligned with the first printed pattern, the image obtained from the subtraction is a uniform color.

On the contrary, if the second pattern has been printed not aligned with the first printed pattern, the image obtained from the subtraction contains only the second printed pattern.

For example, in the case of images acquired from monochrome cameras, pixels with values of gray are subtracted. In other variants, color cameras can also be used.

Therefore, the zones with the same colorings determine a black color, the zones with different colorings determine a white color, or a gray color near to white. If the two printed patterns of the two images are perfectly superimposed and aligned, the image subtracted is, for example, totally black.

In some embodiments, the image subtraction operation is carried out in real time so as not to affect the cycle time during the production operation.

In some embodiments, the time needed to perform the image subtraction operation is in the range of some tenths of a millisecond.

Furthermore, the duration of the image subtraction operation may depend on the resolution of the image that is acquired. In some examples, the image is acquired using a plurality of cameras with a resolution sensor of 5 Mpixels, for example four cameras of 5 Mpixels.

In some embodiments, in order to correctly subtract the two images, the printed patterns included in the two images are first superimposed carefully.

For the superimposition operation, some embodiments provide to calculate the center of the first printed pattern and then the center of the second printed pattern, and to superimpose the two printed patterns making the two corresponding centers overlap, and finally the two images are subtracted as described above.

The two operations, superimposition and subtracting, can be carried out practically simultaneously, but can also be carried out in two distinct operations.

After the subtraction operation, in some embodiments an operation is provided to filter the image obtained by the subtraction, in which filters can be used to clean the image obtained. In some embodiments, the filters eliminate some levels of gray identified as spurious elements, for example caused by background light.

In some embodiments the subtraction can be carried out on the whole of the images, or on specific zones. For example, to align one print with another it can be sufficient, in some embodiments, to operate for example on four peripheral zones, for example four zones at the tops of the first and second print, and it may not be necessary to use the center. In some basic embodiments, also depending on the accuracy required, to align one print on the other it could be sufficient to operate the image subtraction only between two zones.

Some embodiments of the control method allow superimposition and alignment accuracy that can be estimated in portions of pixel: therefore, from 5 to 50 micron, considering that the characteristic dimensions of a pixel range from 10 to 100 micron, also depending on the resolution, high or low, of the sensor of the camera used.

Some embodiments provide a precise control method, since the image subtraction operation, possibly combined with the filtering operation described above, also has the function of cleaning the image and hence limiting the damage of possible print smudges that, with known techniques, would be completely visible and could therefore possibly influence the alignment.

Some embodiments provide a control method applicable both to standard print operations, in which for example silver based conductor pastes are used, and also in operations where a silver based conductor paste is superimposed on highly doped zones, for example to make selective emitters. Some embodiments provide that the method is particularly efficient and useful when prints with a low color contrast are to be superimposed.

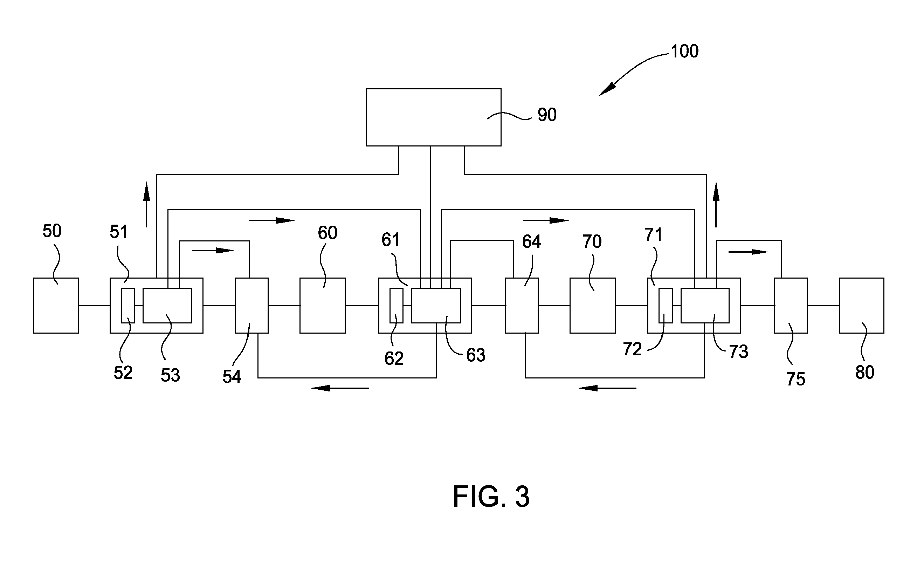

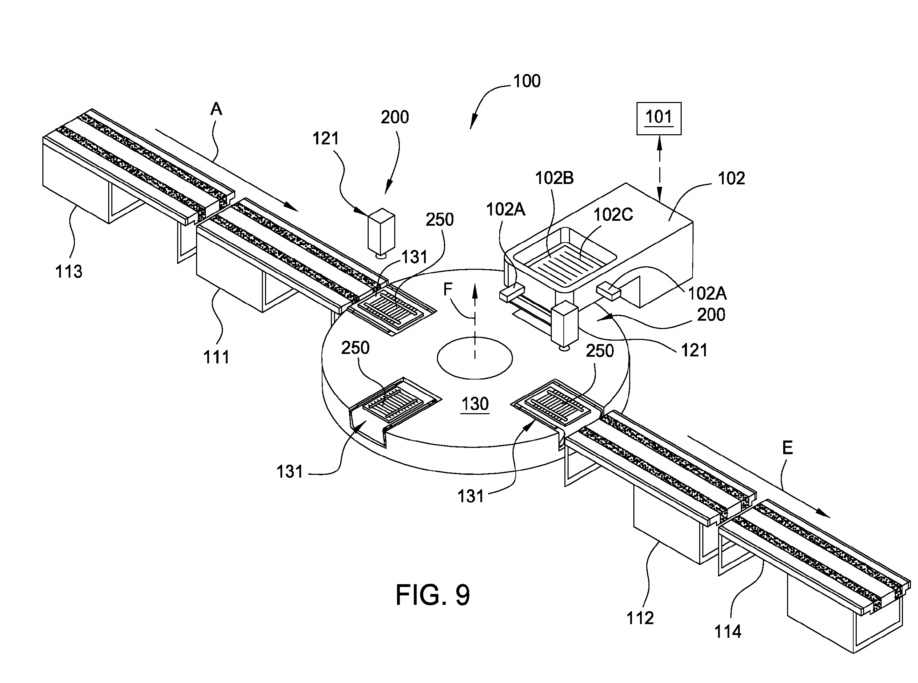

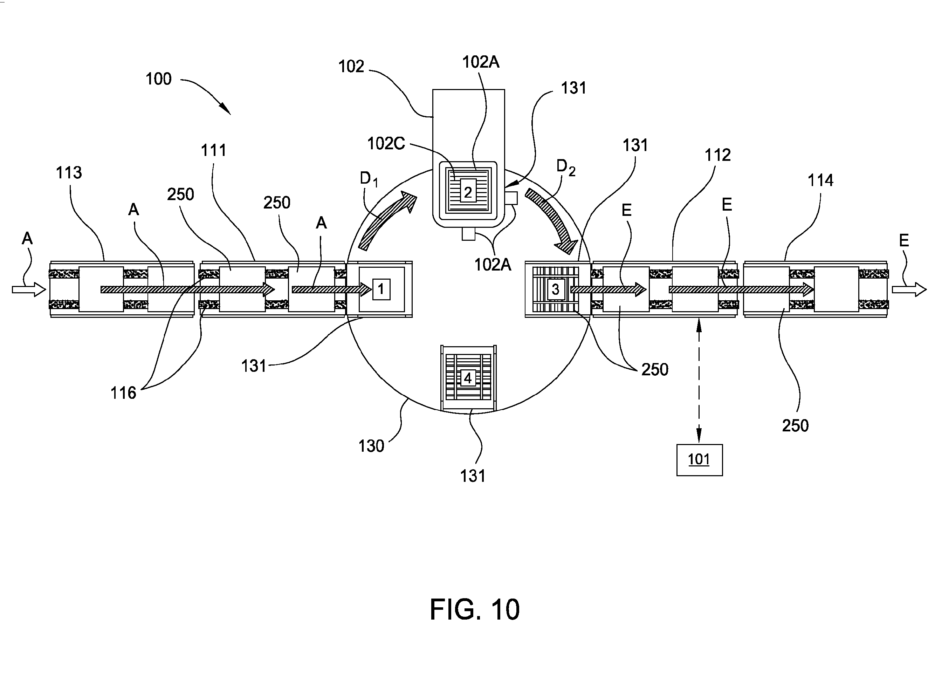

Figure 3 is a schematic view of a system 100 that is able to carry out the method shown in Figures 1 and 2. The arrows in Figure 3 indicate the direction of the data flow between the various parts of the system 100. In one embodiment, the system 100 comprises, in succession, a first printing station 50, a first control station 51, a first alignment device 54, a second printing station 60, a second control station 61, a second alignment device 64, a third printing station 70, a third control station 71, a quality control station 75, a discharge station 80 and a central control and data processing unit 90. In one embodiment, the first, second and third printing stations 50, 60, 70 include a plurality of actuators (e.g., operationper motors or servomotors) that are in communication with the first, second and control stations, 51, 61, 71 and are used to adjust the position and/or angular orientation of a screen printing mask disposed within the first, second and third printing stations 50, 60, 70 with respect to the substrate being printed. In one configuration, as discussed further below, the first, second and third printing stations 50, 60, 70 may each include a printing chamber 102 (Figures 9 and 10) that has a plurality of actuators 102A that are in communication with the first, second and control stations, 51, 61, 71 and are used to adjust the position and/or angular orientation of a screen printing mask 102B (Figures 9 and 10) disposed within the first, second and third printing stations 50, 60, 70 with respect to the substrate being printed. In one embodiment, the screen printing mask 102B is a metal sheet or plate with a plurality of features 102C, such as holes, slots, or other apertures formed therethrough to define a pattern and placement of screen printed material (i.e., ink or paste) on a surface of a substrate. In general, the screen printed pattern that is to be deposited on the surface of a substrate is aligned to the substrate in an automated fashion by orienting the screen printing mask in a desired position over the substrate surface using the actuators and information received by the first, second and third control stations, 51, 61, 71. An automated squeegee type device (not shown) maybe used to urge the screen print material through the features 102C to form the patterned screen printed material on a surface of a substrate.

In one embodiment, each control station 51, 61, 71 comprises detection devices 52, 62, 72 and a command and control unit 53, 63, 73, respectively. In some configurations, each of the control stations 51, 61, 71 may include a system controller that facilitates the control and automation of the processes performed within a desired region of the system and may include a central processing unit (CPU) (not shown), memory (not shown), and support circuits (or I/O) (not shown). The CPU may be one of any form of computer processors that are used in industrial settings for controlling various chamber processes and hardware (e.g., conveyors, optical inspection assemblies, motors, fluid delivery hardware, etc.) and monitor the system and chamber processes (e.g., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller determines which tasks are performable on a substrate. Preferably, the program is software readable by the system controller, which includes code to generate and store at least the optical images, substrate positional information, the sequence of movement of the various controlled components, substrate optical inspection system information, and any combination thereof. In one embodiment of the present invention, the system controller includes pattern recognition software to resolve the positions of the deposited layer(s) on the surface of a substrate.

Referring to Figure 2, in one embodiment of the first printing operation 11, a silk-screen printing is carried out on a surface of the substrate, for example a silicon based wafer, to form a first layer of a multilayer pattern. First printing operation 11 corresponds with the first printing station 50 of Figure 3, in which the substrate is fed by means of known feed systems. The feed system is generally a robotic device, such as a transfer robot, that is configured to transfer the substrate between each of the printing stations, control stations, alignment devices and discharge stations..

Downstream of the first printing operation 11, one embodiment of a method of screen printing provides a first operation 12a of acquiring a first optical image of the first printed layer printed on the substrate, by means of a first detection device 52, to identify the position thereof on the substrate, as indicated by first image 504 in Figure 5. The first image 504 can be memorized in a first command and control unit 53 of the first control station 51 and possibly transmitted to a second command and control unit 63 of the second control station 61, or directly transmitted and memorized in the central control and data processing unit 90, according to operating modes. The information relating to the position of the first patterned layer can be sent to the first alignment device 54. The first acquisition operation 12a may be followed by the first alignment operation 13 in which, in relation to the position of the first printed layer, the first alignment device 54, for example thrusters, or actuators, position the substrate correctly for the execution of the second printing operation 21. In another embodiment, the correct positioning of the substrate is achieved by an aligning device that moves the substrate below the printing head portion of the second printing station 60. The first alignment devices 54 can also provide actuators (e.g., actuators 102A) for positioning the printing heads (e.g. print mask 102B) present in the second printing station 60.

After the second printing operation 21, in which the second layer 502 (Figure 5) of the pattern is printed on the substrate over the first layer 500, the present invention provides a second operation 22a to acquire a second optical image of the second patterned layer printed on the substrate together with the first printed layer, by means of a second detection device 62, as indicated by second image 506 in Figure 5. The second image 506 can be memorized in the second command and control unit 63 of the second control station 61 and possibly transmitted to a third command and control unit 73 of the third control station 71, or directly transmitted and memorized in the central control and data processing unit 90, according to operating modes. Furthermore, the second command and control unit 63 of the second control station 61 carries out a first calculation operation 22b by image subtraction between the second image 506 and the first image 504, and the outcome of the calculation, which in substance identifies the actual position of the individual second layer 502 on the substrate, as indicated by the third image 508 in Figure 5, is used in a closed-loop to suitably command the first alignment devices 54, and is also processed by the quality control station 75.

The information concerning the position of the second patterned layer 502 can be sent to the first alignment devices 54. In particular, in the event that said data are not consistent, the second command and control unit 63 of the second control station 61 sends a feed-back signal to the first alignment device 54 to communicate the non-consistency so that the error can be corrected on subsequently processed substrates.

The second acquisition operation 22a may be followed by a second alignment operation 23 in which, in relation to the position of the second printed layer, the second alignment devices 64, for example thrusters, or actuators, position the substrate correctly for the execution of the third printing operation 31. After the second alignment operation 23, the third printing operation 31 and a third verification operation 32 are carried out. In particular, in the third printing operation 31, in correspondence with the third printing station 70, a third layer of the patterned material is printed on the substrate. Then, in the third verification operation 32, a third operation 32a is performed to acquire the third optical image of the third patterned layer printed on the second layer 502 by use of a third detection device 72.

The third image can be memorized in the third command and control unit 73 of the third control station 71 or in the central control and data processing unit 90, according to operating modes. Moreover, in the third verification operation 32, the third command and control unit 73 of the third control station 71 performs a second calculation operation 32b by image subtraction between the third image and the second image 506, or between the third image and the first image 504 and the outcome of the image subtraction performed in the first calculation operation 22b may be used to form the overall outcome of the calculation, which in substance identifies the position of the single third layer on the substrate, is used in closed-loop process to suitably command the second alignment device 64, and is also processed by the quality control station 75.

The information concerning the position of the third patterned layer can be sent to the second alignment devices 64. In particular, in the event that said data are not consistent, the third command and control unit 73 of the third control station 71 sends a feed-back signal to the second alignment devices 64 to communicate the non-consistency. The quality control station 75 sends a signal to the discharge station 80 which, in the discharge operation, discharges from the system, or plant, the substrate produced, either to the final warehouse or to the discarded wafer storage bins.

Each command and control unit 53, 63, 73 also supplies the data detected to the central control and data processing unit 90 which organizes, memorizes the data collected according to data bases predefined by the user, and processes them in the forms and ways requested by the user, for example statistically, or in such a manner as to identify the critical points of the production process.

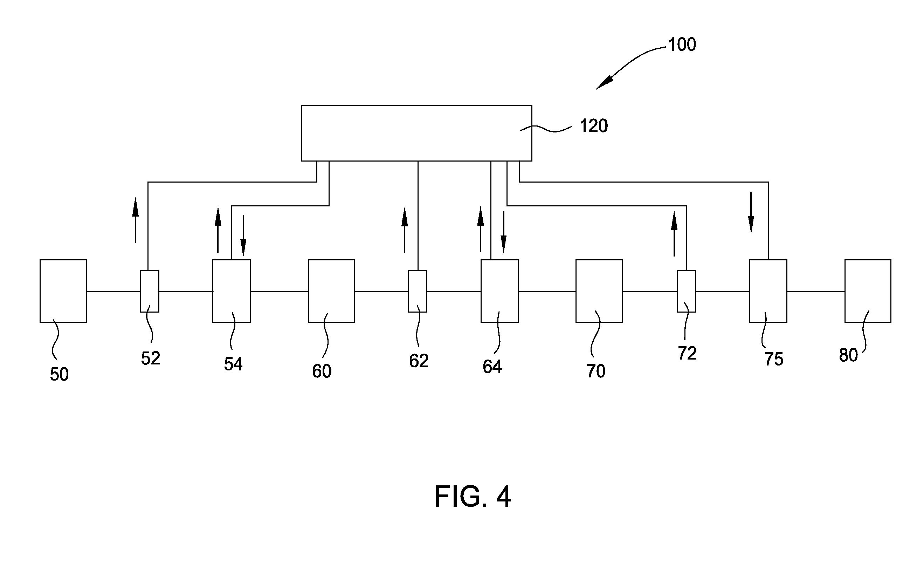

According to another embodiment, shown in Figure 4, all the data transmission sub-operations can be governed by a single central command and control unit 120 that processes the data arriving from the detection devices 52, 62, 72 downstream of each printing station 50, 60, 70, compares the received data according to preset programs and transmits the control signals to the different alignment devices 54, 64. In some configurations, the central control and data processing units 90 and/or 120 may include a system controller that facilitates the control and automation of the processes performed within a desired region of the system and may include a central processing unit (CPU) (not shown), memory (not shown), and support circuits (or I/O) (not shown). The control units 90 and 120 as referred above can be, in general, configured as the above-mentioned control units 53, 63, 73.

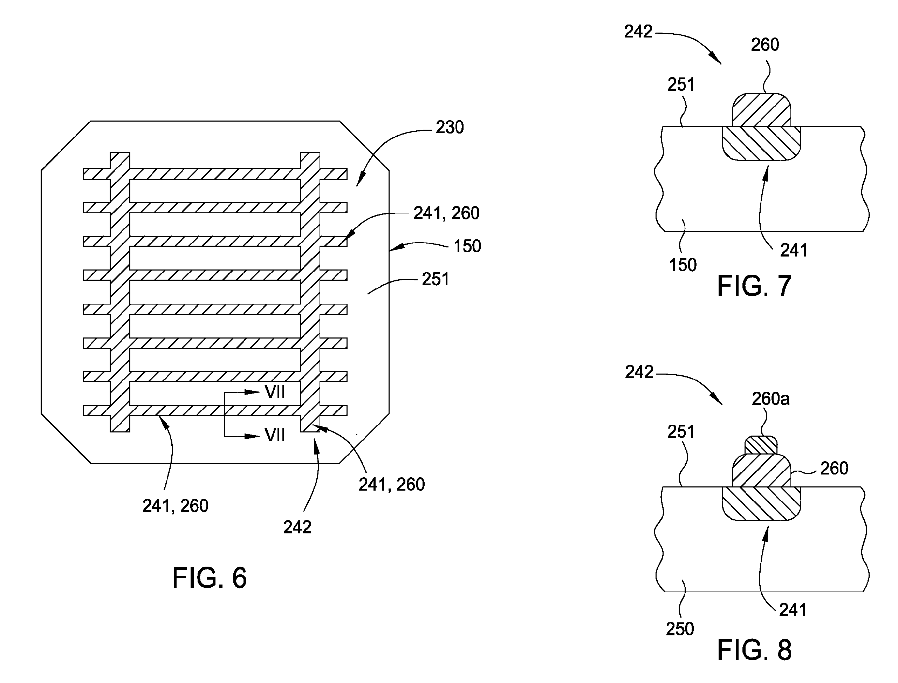

Embodiments of the invention, related to the more general printing operations 11, 21, 31 described above, specifically apply to a solar cell formation process that includes the formation of metal contacts, for example of silver, with double printing, over heavily doped regions 241 that are formed in a desired multilayer pattern 230 on a surface of a substrate 250, seen in Figures 6 and 7.

The double printing performed can be finalized for example to make superimposed fingers having different sizes in width, or superimposed fingers having the same sizes in width but made with different materials or with different functions, or a combination of these two types. For example, embodiments of the invention provide a double printing mode in which, in the first printing operation 11 a dopant paste is printed to form the heavily doped regions 241, in the second printing operation 21 a wide metal line, for example of silver, defining wide fingers 260 is printed on the heavily doped regions 241 and in the third printing operation 31 a narrow metal line, for example of silver, defining narrow fingers 260A is printed on the wide metal line, forming a metal contact structure 242 with a multilayer pattern 230, seen in Figures 6, 7, and 8. One will note that one or more thermal processing operations may be performed on the substrate in the system between each of the printing operations (e.g., operations 11, 21, 31) to further process the printed layers, such as driving in the dopant atoms in the dopant paste to form the heavily doped regions 241 and/or densifying and forming a good electrical contact between a metal material found in the second and third printed layers and the substrate surface (e.g., heavily doped regions 241).

In one embodiment, a double printing process may be used in which, after the first printing operation 11, the second printing operation 21 provides a printing operation to form metallize fingers 260 by means of a contact paste, for example comprising a silver-based material, and the following third printing operation 31 provides a printing operation to form metallize fingers 260a by means of a conductive paste, for example comprising a silver-based material, which is different from the contact paste.

Figure 6 is plan view of a surface 251 of the substrate 250 that has the heavily doped region 241 and a patterned metal contact structure 242 formed thereon, such as the fingers 260. Figure 7 illustrates a portion of the surface 251 having the metal finger 260, for example made of silver, disposed on the heavily doped region 241. The metal contact structure, such as fingers 260 and busbars, are formed on the heavily doped regions 241 so that a high quality electrical connection can be formed between these two regions. Low-resistance, stable contacts are critical for the performance of the solar cell. The heavily doped regions 241 generally comprise a portion of the substrate 250 material that has about 0.1 atomic % or less of dopant atoms disposed therein. A patterned type of heavily doped regions 241 can be formed by conventional lithographic and ion implantation techniques, or conventional dielectric masking and high temperature furnace diffusion techniques that are well known in the art. Formation of a patterned heavily doped regions 241 can also be formed by use of a screen printing process and post screen printing thermal process, as also discussed herein. However, the processes of aligning and depositing the metal contact structure 242 on the heavily doped regions 241 is generally not possible using conventional techniques, since there is typically no way to optically determine the actual alignment and orientation of the formed heavily doped region 241 pattern on the surface 251 of the substrate 250 using these techniques.

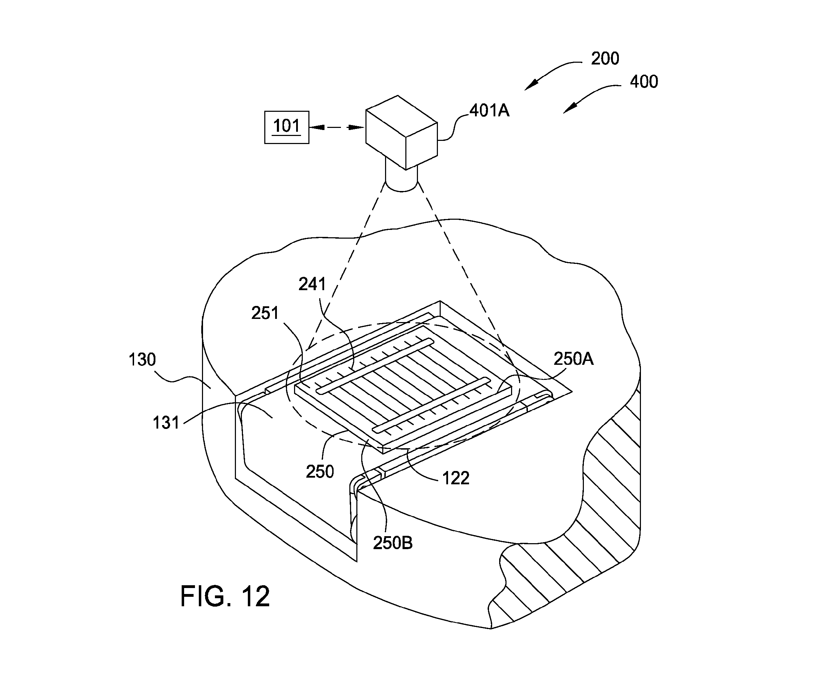

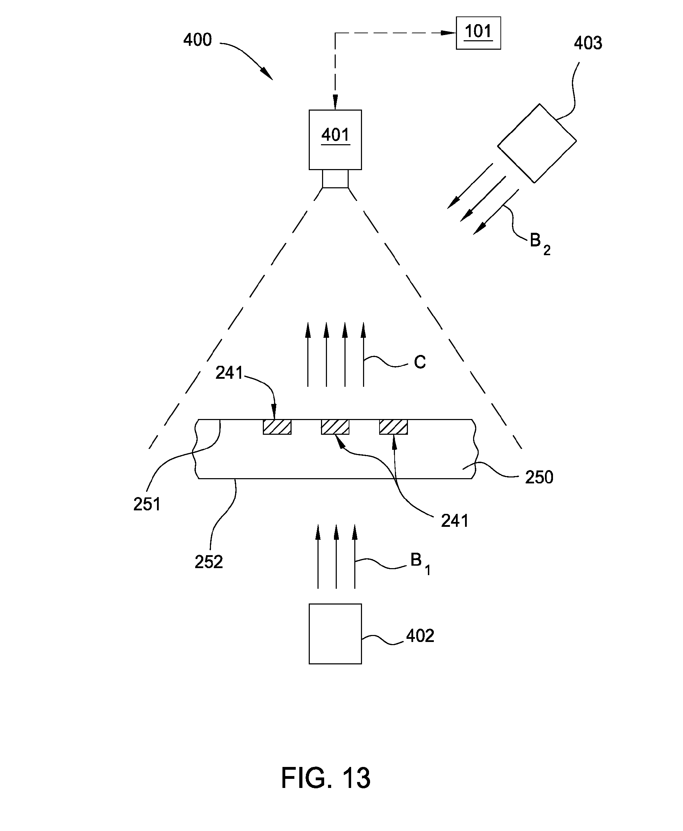

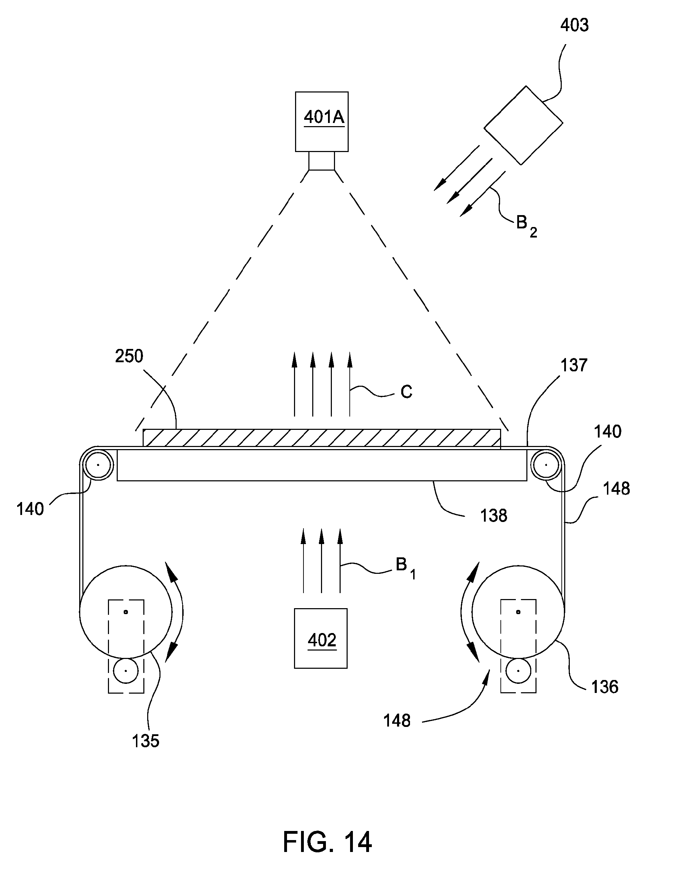

In another embodiment, more precisely described below, one or more, or each, of the above-mentioned printing stations 50, 60, 70 can be configured as a printing system 110 described in connection with Figures 8, 9 and 10. Furthermore, the control stations 51, 61, 71, that are provided with detection device 52, 62, 72 and control units 53, 63, 73, can be configured as an inspection system 400 described below in connection with Figures 12, 13 and 14 associated with the system controller 101 exemplified in Figures 9, 10, 12, and 13. In particular, control units 53, 63, 73 can be configured as the system controller 101 described hereinafter. The above-mentioned alignment device 54, 64 can be configured as actuators 102A described below in connection with printing chamber 102 of Figures 9 and 10.

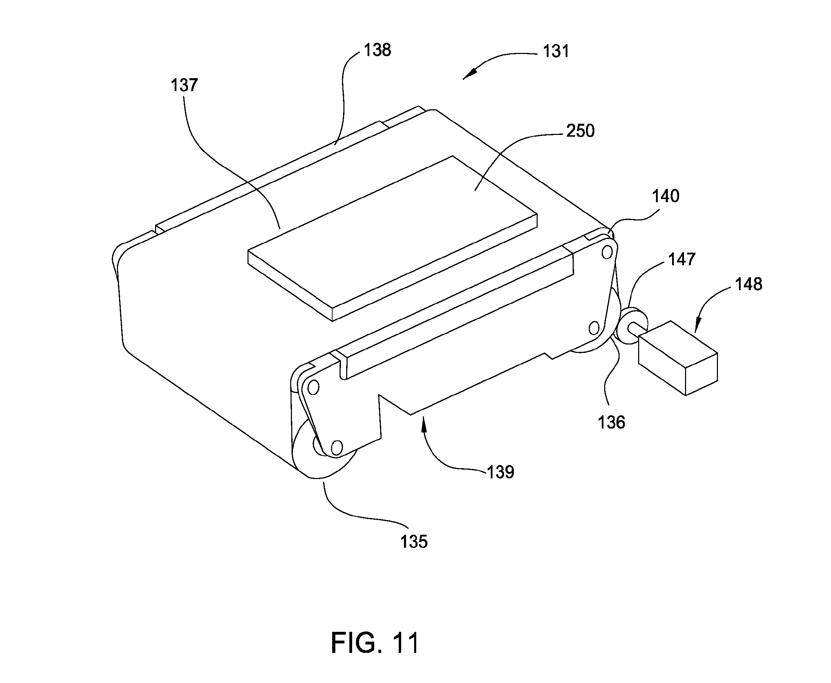

According to one embodiment of the invention, Figure 9 is a schematic isometric view and Figure 11 is a schematic top plan view illustrating one embodiment of a portion of a screen printing system 110, that may form at least part of one or more of the printing stations 50, 60, 70 of the system 100 of Figures 3 and 4, and used to form the metal contacts in a desired pattern on a surface of a solar cell substrate 250 using an optical inspection system 400, seen in Figures 12, 13 and 14. In one embodiment, the screen printing system 110 comprises an incoming conveyor 111, a rotary actuator assembly 130, a screen print chamber 102, and an outgoing conveyor 112. The incoming conveyor 111 may be configured to receive a substrate 250 from an input device, such as an input conveyor 113 (i.e., path "A" in Figure 10), and transfer the substrate 250 to a printing nest 131 coupled to the rotary actuator assembly 130. The outgoing conveyor 112 may be configured to receive a processed substrate 250 from a printing nest 131 coupled to the rotary actuator assembly 130 and transfer the substrate 250 to a substrate removal device, such as an exit conveyor 114 (i.e., path "E" in Figure 10). The input conveyor 113 and the exit conveyor 114 may be automated substrate handling devices that are part of a larger production line. In one embodiment, one or more of the conveyors 111, 112, 113, 114 may be used to transport substrates between any two of the stations in the system 100, such as between any two of the following: the first printing station 50, the first control station 51, the second printing station 60, the second control station 61, the third printing station 70, the third control station 71, the quality control station 75 and the discharge station 80.

The rotary actuator assembly 130 may be rotated and angularly positioned about the "F" axis by a rotary actuator (not shown) and a system controller 101, such that the printing nests 131 may be selectively angularly positioned within the screen printing system 110 (e.g., paths "D1" and "D2" in Figure 10). The rotary actuator assembly 130 may also have one or more supporting components to facilitate the control of the print nests 131 or other automated devices used to perform a substrate processing sequence in the screen printing system 110.

In one embodiment, the rotary actuator assembly 130 includes four printing nests 131, or substrate supports, that are each adapted to support a substrate 250 during the screen printing process performed within the screen print chamber 102. Figure 10 schematically illustrates the position of the rotary actuator assembly 130 in which one printing nest 131 is in position "1" to receive a substrate 250 from the incoming conveyor 111, another printing nest 131 is in position "2" within the screen print chamber 102 so that another substrate 250 can receive a screen printed pattern on a surface thereof, another printing nest 131 is in position "3" for transferring a processed substrate 250 to the outgoing conveyor 112, and another printing nest 131 is in position "4", which is an intermediate stage between position "1" and position "3".

As illustrated in Figure 11, a printing nest 131 generally consists of a conveyor assembly 139 that has a feed spool 135, a take-up spool 136, rollers 140 and one or more actuators 148, which are coupled to the feed spool 135 and/or take-up spool 136, that are adapted to feed and retain a supporting material 137 positioned across a platen 138. The platen 138 generally has a substrate supporting surface on which the substrate 250 and supporting material 137 are positioned during the screen printing process performed in the screen print chamber 102. In one embodiment, the supporting material 137 is a porous material that allows a substrate 250, which is disposed on one side of the supporting material 137, to be retained on the platen 138 by a vacuum applied to the opposing side of the supporting material 137 by a conventional vacuum generating device (e.g., vacuum pump, vacuum ejector). In one embodiment, a vacuum is applied to vacuum ports (not shown) formed in the substrate supporting surface 138A of the platen 138 so that the substrate can be "chucked" to the substrate supporting surface 138A of the platen. In one embodiment, the supporting material 137 is a transpirable material that consists, for instance, of a transpirable paper of the type used for cigarettes or another analogous material, such as a plastic or textile material that performs the same function.

In one configuration, the actuators 148 are coupled to, or are adapted to engage with, the feed spool 135 and a take-up spool 136 so that the movement of a substrate 250 positioned on the supporting material 137 can be accurately controlled within the printing nest 131. In one embodiment, feed spool 135 and the take-up spool 136 are each adapted to receive opposing ends of a length of the supporting material 137. In one embodiment, the actuators 148 each contain one or more drive wheels 147 that are coupled to, or in contact with, the surface of the supporting material 137 positioned on the feed spool 135 and/or the take-up spool 136 to control the motion and position of the supporting material 137 across the platen 138.

In one embodiment, the screen printing system 110 may include an inspection assembly 200 adapted to inspect a substrate 250 located on the printing nest 131 in position "1". The inspection assembly 200 may include one or more cameras 121 positioned to inspect an incoming, or processed substrate 250, located on the printing nest 131 in position "1". In this configuration, the inspection assembly 200 includes at least one camera 121 (e.g., CCD camera) and other electronic components capable of inspecting and communicating the inspection results to the system controller 101 used to analyze the orientation and position of the substrate 250 on the printing nest 131. In another embodiment, the inspection assembly 200 comprises the optical inspection system 400, discussed above.

The screen print chamber 102 is adapted to deposit material in a desired pattern on the surface of a substrate 250 positioned on a printing nest 131 in position "2" during the screen printing process. In one embodiment, the screen print chamber 102 includes a plurality of actuators, for example, actuators 102A (e.g., operationper motors or servomotors) that are in communication with the system controller 101 and are used to adjust the position and/or angular orientation of a screen printing mask 102B (Figure 6) disposed within the screen print chamber 102 with respect to the substrate 250 being printed. In one embodiment, the screen printing mask 102B is a metal sheet or plate with a plurality of features 102C (Figure 6), such as holes, slots, or other apertures formed therethrough to define a pattern and placement of screen printed material (i.e., ink or paste) on a surface of a substrate 250. In general, the screen printed pattern that is to be deposited on the surface of a substrate 250 is aligned to the substrate 250 in an automated fashion by orienting the screen printing mask 102B in a desired position over the substrate surface using the actuators 102A and information received by the system controller 101 from the inspection assembly 200. In one embodiment, the screen print chamber 102 is adapted to deposit a metal containing or dielectric containing material on a solar cell substrate having a width between about 125 mm and 156 mm and a length between about 70 mm and about 156 mm. In one embodiment, the screen print chamber 102 is adapted to deposit a metal containing paste on the surface of the substrate to form the metal contact structure on a surface of a substrate.

In one embodiment, detection devices 52, 62, 72 are represented by an optical inspection system 400, shown in Figure 12, Figure 13 and Figure 14. Optical inspection system 400 is configured to determine the actual alignment and orientation of the pattern 230 of the heavily doped region(s) 241 formed on a surface of a substrate 250. The optical inspection system 400 generally contains one or more electromagnetic radiation sources, such as radiation sources 402 and 403 that are configured to emit radiation at a desired wavelength and a detector assembly 401 that is configured to capture the reflected or un-absorbed radiation so as to acquire relative optical images of the printed patterned layers, so that the alignment and orientation of the heavily doped regions 241 and the wide fingers 260 and the narrow fingers 260A of the multilayer pattern can be optically determined relative to the other non-heavily doped regions of the substrate 250. The optical images acquired by the detector assembly 401, from which the orientation and alignment data is derived, is then delivered to a system controller 101 that is configured to operate the calculation operation 32a, 32b by image subtraction and consequently to adjust and control in a closed-loop the placement alignment of the substrate for the purpose of the second printing operation 21 and the third printing operation 31 of the metal contact structure, such as wide fingers 260 and narrow fingers 260a, on the surface of the heavily doped regions 241 by use of patterned metallization technique.

Furthermore, the same optical images acquired by the detector unit 401 may also be used for quality control.

Patterned metallization techniques may include screen printing processes, ink jet printing processes, lithographic and blanket metal deposition process, or other similar patterned metallization processes. In one embodiment, the metal contacts are disposed on the surface of the substrate 250 using a screen printing process performed in a screen printing system 100, as discussed below in conjunction with Figures 9-12.

In configurations where the heavily doped regions 241 are formed within a silicon substrate it is believed that electromagnetic radiation emitted at wavelengths within the ultraviolet (UV) and infrared (IR) wavelength regions will either be preferentially absorbed, reflected or transmitted by the silicon substrate or heavily doped regions. The difference in the transmission, absorption or reflection of the emitted radiation can thus be used to create some discernable contrast that can be resolved by the detector assembly 401 and system controller 101. In one embodiment, it is desirable to emit electromagnetic radiation at wavelengths between about 850 nm and 4 microns (µm). In one embodiment, one or more of the radiation sources 402 and 403 are light emitting diodes (LEDs) that are adapted to deliver on or more of the desired wavelengths of light.

In one embodiment, the optical inspection system 400 has a radiation source 402 that is configured to deliver electromagnetic radiation "B1" to a surface 252 of a substrate 250 that is opposite to the side of the substrate on which the detector assembly 401 is disposed. In one example, the radiation source 402 is disposed adjacent to the backside of a solar cell substrate 250 and the detector assembly 401 is disposed adjacent to the front surface of the substrate 250. In this configuration, it is desirable to use optical radiation greater than the absorption edge of silicon, such as greater than 1060 nm to allow that emitted electromagnetic radiation "B1" to pass through the substrate 250 and be delivered to the detector assembly 401 following path "C". It is believed that due to the high doping level (e.g., >10¹⁸ atoms/cm³) in the heavily doped regions versus the typically lightly doped silicon substrate (e.g., <10¹⁷ atoms/cm³), typically used in solar cell applications, the absorption or transmissive properties will be significantly different for each of these regions within these wavelengths. In one embodiment, it is desirable to confine the emitted wavelengths in a range between about 1.1 µm and about 1.5 µm. In one example, the heavily doped regions have a resistivity of at least 50 Ohms per square.

In another embodiment of the optical inspection system 400, a radiation source 403 is configured to deliver electromagnetic radiation "B2" to a surface 251 of a substrate 250 that is on the same side of the substrate as the detector assembly 401, so that one or more of the emitted wavelengths will be absorbed or reflected by portions of the substrate 250 or the heavily doped regions 241 and the wide fingers 260 and narrow fingers 260A, and emitted to the detector unit 401 following path "C". In this configuration, it is desirable to emit optical radiation at wavelengths between about 850 nm and 4 microns (µm) until a desired contrast between the regions can be detected by the detector assembly 401.

In one embodiment of the optical inspection system 400, two radiation sources 402 and 403 and one or more detector assemblies 401 are used to help further detect the pattern of the heavily doped regions 241, the wide fingers 260 and narrow fingers 260A, on the surface of the substrate 250. In this case, it may be desirable to configure the radiation sources 402 and 403 so that they emit radiation at the same or different wavelengths.

The detector assembly 401 includes an electromagnetic radiation detector, camera or other similar device that is configured to measure the intensity of the received electromagnetic radiation at one or more wavelengths. In one embodiment, the detector assembly 401 includes a camera 401A that is configured to detect and resolve features on a surface of a substrate within a desired wavelength range emitted by one or more of the radiation sources 402 or 403. In one embodiment, the camera 401A is an InGaAs type camera that has a cooled CCD array to enhance the signal-to-noise ratio of the detect signal. In some configurations, it is desirable to isolate the detector assembly 401 from ambient light by enclosing or shielding the areas between the surface 251 of the substrate 250 and the camera 401A.

In one embodiment, the detector assembly 401 also includes one or more optical filters (not shown) that are disposed between the camera 401A and the surface of the substrate 251. In this configuration, the optical filter(s) are selected to allow only certain desired wavelengths to pass to the camera 401A to reduce the amount of unwanted energy being received by the camera 401A to improve the signal-to-noise ratio of the detected radiation. The optical filter(s) can be a bandpass filter, a narrowband filter, an optical edge filters, a notch filter, or a wideband filter purchased from, for example, Barr Associates, Inc. or Andover Corporation. In another aspect of the invention, an optical filter is added between the radiation sources 402 or 403 and the substrate 250 to limit the wavelengths projected onto the substrate and detected by the camera 401A. In this configuration, it may be desirable to select radiation sources 402 or 403 that can deliver a broad range of wavelengths and use filters to limit the wavelengths that strike the surface of the substrate.

Embodiments of the invention thus provide to determine the actual alignment and orientation of the patterned heavily doped regions 241, printed in the first printing operation 21, corresponding to the verification operations 12, 22, 32 as above, and then forming - second and third printing operation 21, 31 - the metal contacts according to a multilayer pattern on the surface of the heavily doped regions 241 using the information collected on each occasion by the calculation operations by image subtraction.

In an effort to directly determine the alignment and orientation of the heavily doped regions 241 formed on the substrate surface 251 prior to forming a patterned conductive layer thereon, the system controller 101 may use one or more optical inspection systems 400 to collect the desired data. Figure 10 illustrates one embodiment of the optical inspection system 400 that is incorporated into part of the printing nest 131 and optical inspection assembly 200. In one embodiment, the inspection assembly 200 comprises a camera 401A, and the printing nest 131 comprises a conveyor assembly 139, a supporting material 137, a platen 138, and a radiation source 402. In this configuration, the radiation source 402 is adapted to emit electromagnetic radiation "B1" to a surface 252 of a substrate 250 through the supporting material 137 and platen 138 on which the substrate 250 is "chucked." The emitted electromagnetic radiation "B1" then passes through portions of the substrate and follows path "C" to the camera 401A that is positioned to receive a portion of the emitted radiation. In general, the supporting material 137 and platen 138 are made from materials and have a thickness that will not significantly affect the signal-to-noise ratio of the electromagnetic radiation received and processed by the camera 401A and system controller 101. In one embodiment, the platen 138 is formed from an optically transparent material, such as sapphire, that will not significantly block the UV and IR wavelengths of light. As discussed above, in another embodiment, a radiation source 403 is configured to deliver electromagnetic radiation "B2" to a surface 251 of a substrate 250 that is positioned on the supporting material 137 and the platen 138 so that one or more of the emitted wavelengths will be absorbed or reflected by portions of the substrate 250 and delivered to the camera 401A following path "C".

Figure 8 is a schematic isometric view of one embodiment of the rotary actuator assembly 130 that illustrates an inspection assembly 200 that is positioned to inspect a surface 251 of a substrate 250 disposed on a printing nest 131.

Typically, the alignment of the pattern 230 on the surface 251 of the substrate 250 is dependent on the alignment of the pattern 230 to a feature of the substrate 250. In one example, the alignment of the pattern 230 is based on the alignment of the screen printing device to a feature on the substrate, such as edges 250A, 250B (Figure 8). The placement of a pattern 230 will have an expected position X and an expected angle orientation R with respect to edges 250A and an expected position Y with respect to an edge 250B of the substrate 250. The positional error of the pattern 230 on the surface 251 from the expected position (X, Y) and the expected angular orientation R on the surface 251 may be described as a positional offset (ΔX, ΔY) and an angular offset ΔR. Thus, the positional offset (ΔX, ΔY) is the error in the placement of the pattern 230 of heavily doped region(s) 241 relative to the edges 250A and 250B, and the angular offset ΔR is the error in the angular alignment of the pattern 230 of heavily doped region(s) 241 relative to the edge 250B of the substrate 250. The misplacement of the screen printed pattern 230 on the surface 251 of the substrate 250 can affect the ability of the formed device to perform correctly and thus affect the device yield of the system 100. However, minimizing positional errors becomes even more critical in applications where a screen printed layer is to be deposited on top of another formed pattern, such as disposing a conductive layer on the heavily doped region(s) 241.

To this purpose, in one embodiment, a camera 401A is positioned over the surface 251 of the substrate 250 so that a viewing area 122 of the camera 121 can inspect at least one region of the surface 251. The information received by the camera 401A is used to align the screen printing mask, and thus subsequently deposited material, to the heavily doped regions 241 by use of commands sent to the actuators 102A from the system controller 101. During normal process sequencing the heavily doped region 241 position information data is collected for each substrate 250 positioned on each printing nest 131 before it delivered to the screen print chamber 102. The inspection assembly 200 may also include a plurality of optical inspection systems 400 that are adapted to view different areas of a substrate 250 positioned on a printing nest 131 to help better resolve the pattern 230 formed on the substrate.

While the foregoing is directed to embodiments of the invention, other and further embodiments of the invention may be devised without departing from the basic scope thereof.

## Claims

1. A method for printing a multilayer pattern on a substrate comprising:
a first printing step comprising depositing a first patterned layer on a region of a surface of a first substrate;
a second printing step comprising depositing a second patterned layer over the region of the surface or first patterned layer;
verifying the precision of the alignment of the second patterned layer relative to the first patterned layer, wherein the verifying comprises:
acquiring a first optical image of the first patterned layer after the first printing step and before the second printing step;
acquiring a second optical image of the second patterned layer after the second printing step; and
determining the position of the second patterned layer on the first substrate by performing a first image subtraction process, wherein the first image subtraction process comprises subtracting the first optical image from the second optical image to form a first subtracted optical image; and
comparing the first subtracted optical image with the first optical image, wherein data created from the comparison is used to adjust a property of a subsequent printing step.

2. The method of claim 1, further comprising:
a third printing step comprising depositing a third patterned layer on the region of the surface of the first substrate;
acquiring a third optical image of the third patterned layer after the third printing step; and
determining the position of the third patterned layer on the first substrate by performing a second image subtraction process, wherein the second image subtraction process comprises subtracting the first optical image from the third optical image to form a second subtracted optical image; and
comparing the second subtracted optical image with the first optical image or the second optical image, wherein data created from the comparison of the second subtracted optical image with the first optical image or the second optical image is used to adjust a property of a second subsequent printing step.

3. The method of claim 1, wherein:
the depositing the first patterned layer further comprises disposing a doping paste on the region of the surface of the first substrate, and
the depositing the second patterned layer further comprises disposing a first metal containing material over at least a portion of the region on which the doping paste was disposed.

4. The method of claim 3, wherein the subsequent printing step comprises a third printing step performed on the first substrate, wherein the third printing step comprises depositing a second metal containing material on the first metal containing material.

5. The method of claim 1, wherein:
the depositing the first patterned layer further comprises disposing a first metal containing material on the region of the surface of the first substrate, and
the depositing the second patterned layer further comprises disposing a second metal containing material over at least a portion of the first metal containing material.

6. The method of claim 1, wherein the first printing step is carried out on the region of the substrate to form the first multilayer pattern.

7. The method of claims 1, 2, 3, 4, 5 or 6, wherein the optical images include an image detected with light in the visible field or infrared field.

8. The method of claims 1, 2 3, 4, 5, 6 or 7, wherein the printing steps are used to form solar cells including the formation of a metal contact with double printing on a heavily doped region, wherein the metal contacts are formed in a first multilayer pattern on the surface of the first substrate.

9. The method of claim 1, wherein a wide metal line is printed to define wide fingers on a heavily doped region in the first printing step, and a thin metal line is printed to define narrow fingers on the wide metal line in the second printing step.

10. The method of claim 3, wherein in the doping paste is disposed on the region of the first substrate to determine heavily doped regions.

11. An apparatus for printing a multilayer pattern on a substrate comprising:
a first printing station configured to print a first patterned layer on the substrate;
a first device operable to align the first patterned layer to a region of a substrate;
at least a second printing station, operable to print a second patterned layer over the first patterned layer; and
at least a control means, operable to verify the precision of the alignment after the printing of the second patterned layer and operable to feed back data from the verification of the precision to the at least one means for alignment, wherein the control means further comprise:
a detection assembly operable to acquire a first optical image of the first patterned layer before the second layer is printed, and a second optical image of the second patterned layer printed on the first patterned layer; and
a control unit operable to carry out image calculation by image subtraction between the second optical image and the first optical image in order to determine an actual position on the substrate of the second patterned printed layer, wherein the control unit is further operable to feed back an outcome of the image calculation to a quality control station.

12. The apparatus of claim 11, further comprising:
a third printing station, and
the control unit further comprises:
a first control station that is coupled to the first printing station and the second printing station, and
a second control station that is coupled to the second printing station and the third printing station.

13. The apparatus of claim 12, wherein the control unit further comprises a third control station that is coupled to the third printing station and the quality control station.

14. The apparatus of claim 12, further comprising an alignment device that comprises:
a first alignment device disposed between the first printing station and the second control station; and
a second alignment device disposed between the second control station and the third printing station.

15. The apparatus of claim 11, wherein the first control station and the second control station each comprise a detection device configured to acquire optical image data and transfer at least a portion of the optical image data to the control unit.
